Europäisches Patentamt

European Patent Office

Office européen des brevets

(11) Publication number: **0 128 107**
**A1**

# EUROPEAN PATENT APPLICATION

(21) Application number: **84630072.1**

(22) Date of filing: **02.05.84**

(51) Int. Cl.³: **G 01 R 31/28**

(30) Priority: **04.05.83 IL 68568**

(43) Date of publication of application:
**12.12.84 Bulletin 84/50**

(84) Designated Contracting States:
**AT BE CH DE FR GB IT LI LU NL SE**

(71) Applicant: **OPTROTECH LTD.**
**P.O. Box 201**
**Nes Ziona(IL)**

(72) Inventor: **Barak, Shlomo, Dr.**
**Rehov Jabotinsky 21**
**Nes Ziona(IL)**

(74) Representative: **Waxweiler, Jean et al,**
**OFFICE DENNEMEYER S.à.r.l. 21-25 Allée Scheffer**
**P.O.Box 41**
**L-2010 Luxembourg(LU)**

(54) Apparatus and method for automatic inspection of printed circuit boards.

(57) Printed circuit board testing apparatus comprising a testing location (10) for a printed circuit board (12) to be tested, high speed scanning apparatus (18) for providing a scanned energy input to conductive locations on the printed circuit board (12) and electron collecting apparatus for sensing the charged state of scanned conductive locations scanned by the scanning apparatus (18).

FIG. I

EP 0 128 107 A1

Croydon Printing Company Ltd.

APPARATUS AND METHOD FOR AUTOMATIC INSPECTION OF PRINTED CIRCUIT BOARDS

The present invention relates to a printed circuit board inspection apparatus and more particularly to apparatus for inspection of printed circuit bearing circuit boards.

Various types of apparatus are known for electronic circuit inspection at different stages in the production thereof. A particularly successful printed circuit board inspection device is described and claimed in applicant's earlier Israel patent application 66599. This device is suitable for providing optical inspection of a single layer bare circuit board, i.e. without components mounted thereon.

Present manufacturing technologies permit multilayer printed circuit boards to be produced. These boards are not susceptible of testing by the above-described optical apparatus. Conventionally, testing of this type of boards is done electrically by determining electrical continuity between various sets of points on the circuit board. Such electrical continuity testing is carried out by using a multi probe electrical contact unit, commonly termed a "bed of nails". This conventional contact unit has a multiplicity of spring loaded pins arranged in a closely spaced grid pattern for contact with a corresponding multiplicity of locations on the circuit board being tested.

The use of the "bed of nails" as the circuit board interface device for circuit board testing apparatus has a number of disadvantages:

1.  It is limited as to density and not suitable for a density of over about 200 pin/sq. in. It is not suitable for off-grid circuit layouts. Such off-grid layouts are becoming increasingly popular as it is desired to increase the density of the circuitry on the board, and to overcome topological problems not solved by computerized PCB design.

2.  The cost of "bed of nails" type testing equipment is extremely high since each spring loaded pin is coupled by a separate conductor to a separate operating switch. Thus conventional testing equipment of this type may include thousands of switches and many kilometers of conductor. This machinery is thus extremely large and complex.

The present invention seeks to overcome the significant disadvantages of the prior art printed circuit testing apparatus exemplified by the "bed of nails" type contact unit.

There is thus provided in accordance with an embodiment of the present invention, printed circuit board testing apparatus comprising a testing location for a printed circuit board to be tested, high speed scanning apparatus for providing a scanned energy input to conductive locations on the printed circuit board, and electron collecting apparatus for sensing the charged state of scanned conductive locations scanned by the scanning apparatus.

Further in accordance with an embodiment of the present invention, there is provided correlating apparatus for correlating information relating to the charged state of the scanned conductive locations for providing an output indication of conduction between sets of scanned locations on the circuit board.

Additionally in accordance with an embodiment of the present invention, in addition to the correlating apparatus there is also provided comparison apparatus for comparing the output indication of conduction with a predetermined reference indication corresponding to a master circuit board.

Further in accordance with an embodiment of the present invention, there is also provided apparatus for providing at least one predetermined electrical input to the printed circuit board being tested.

Additionally in accordance with a preferred embodiment of the invention, the electrical input providing apparatus may provide at least one time varying electrical input to the printed circuit board and the correlation apparatus may provide a plurality of output indications each corresponding to a different state of the electrical input supplied to the printed circuit board. The scanning apparatus may comprise optical scanning apparatus, such as UV scanning apparatus. According to an alternative embodiment of the invention, the scanning apparatus may comprise electron scanning apparatus.

- 3 -

The present invention will be understood and appreciated more fully from the following detailed description taken in conjunction with the drawings in which:

Fig. 1 is a block diagram illustration of printed circuit board inspection and testing apparatus constructed and operative in accordance with a preferred embodiment of the invention;

Fig. 2 is a partially schematic, partially block diagram illustration of one embodiment of the apparatus of Fig. 1 employing optical scanning;

Fig. 3 is a sectional side view illustration of an inspection chamber useful in connection with the embodiment of Fig. 2;

Fig. 4 is a partially schematic, partially block diagram illustration of another embodiment of the apparatus of Fig. 1 employing electron beam scanning;

Fig. 5 is a sectional side view illustration of an inspection chamber useful in connection with the embodiment of Fig. 4;

Fig. 6 is a pictorial illustration of a printed circuit board located inside an inspection chamber of the type illustrated in Fig. 3;

Fig. 7 is a block diagram illustration of a portion of the circuitry of Fig. 2; and

Fig. 8 is a block diagram illustration of a portion of the circuitry of Fig. 2.

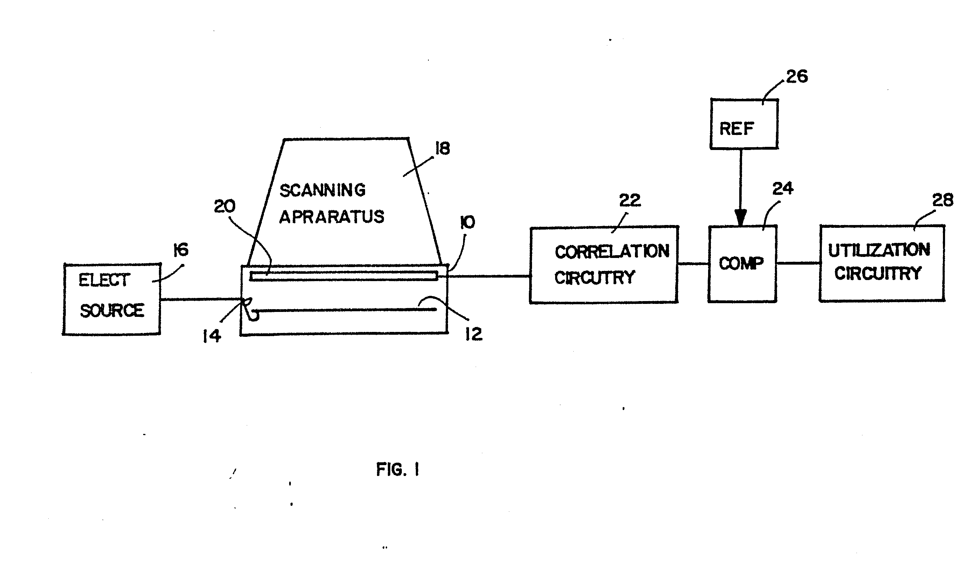

Reference is now made to Fig. 1 which illustrates the apparatus of the invention in a general format and indicates that it includes an inspection chamber or location 10 at which a printed circuit board 12 is located during testing thereof. The inspection chamber 10, which is normally maintained at a subatmospheric pressure, is provided with an electrical connection cable 14 for coupling the electrical circuits on the circuit board to an external electrical signal or potential source 16. Associated with inspection chamber 10 is scanning apparatus 18, which may be any suitable type of electrical or optical scanning apparatus, as will be described hereinbelow in greater detail.

Apparatus 20 for sensing the electrical potential of locations on the printed circuit board being tested is associated with the inspection chamber 10 and with the scanning apparatus 18 and provides an output signal indicating the charged state of locations on the printed circuit board to correlation circuitry 22 which is operative to provide an output indication of conduction between sets of scanned locations on the printed circuit board being tested. Correlation circuitry 22 may also receive input signals from the scanning apparatus 18 or from other control or sensing circuitry for correlation purposes.

The output of correlation circuitry 22 may be supplied to further signal processing circuitry, such as a comparator 24, which may compare the output indication of conduction with a reference standard supplied by a reference source 26 indicative of the characteristics of a master circuit board. The output of comparator 24 may be supplied to utilization circuitry 28, such as a display, or a defect marker.

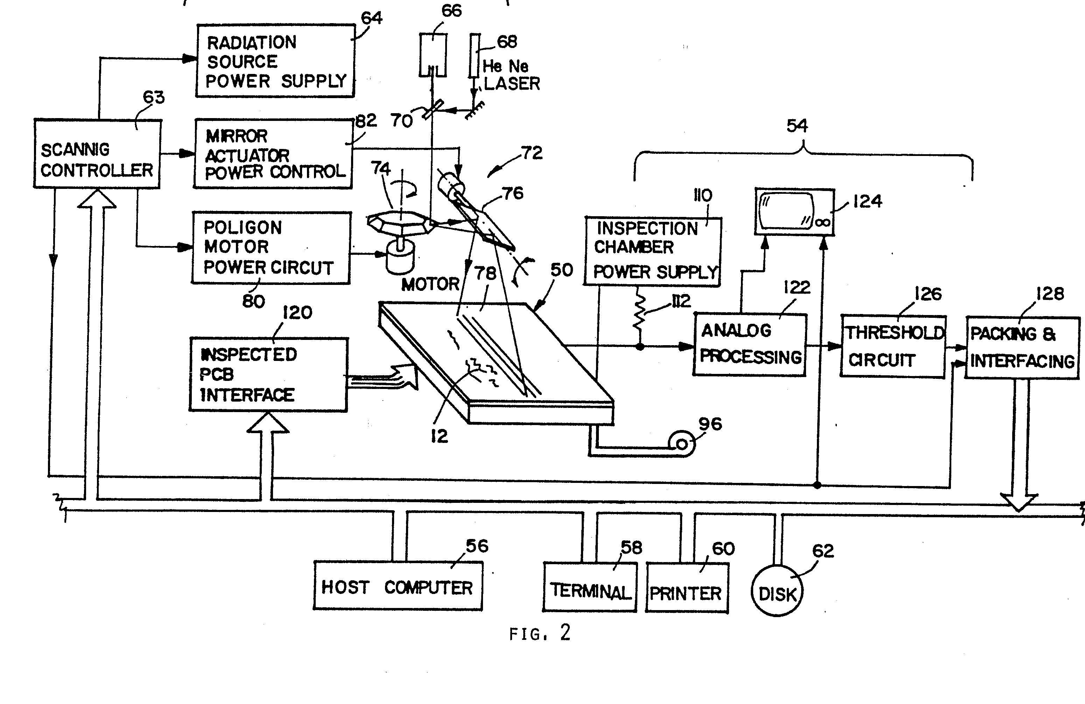

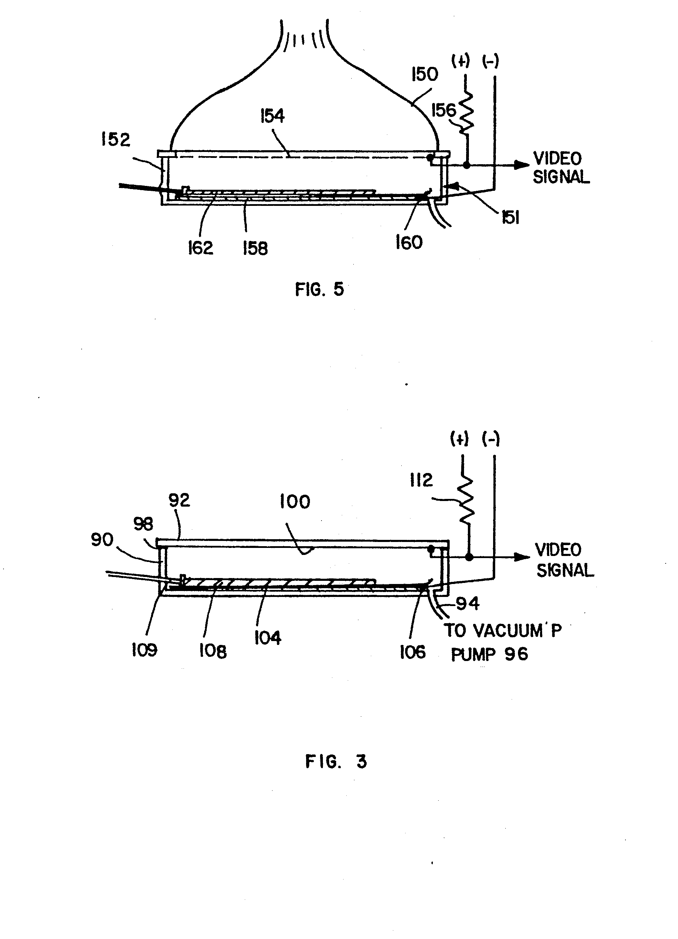

Reference is now made to Fig. 2, which is a partially schematic, partially block diagram illustration of printed circuit board testing and inspection apparatus constructed and operative in accordance with a preferred embodiment of the present invention and employing optical scanning. The apparatus of Fig. 2 comprises an inspection chamber 50 which will be described in detail hereinbelow in connection with Fig. 3, an optical scanning sub-system, indicated generally at reference numeral 52 and a signal processing sub-system, indicated generally at reference numeral 54. Common to all of the foregoing elements is a computer 56 which coordinates system operation and is associated with a conventional terminal 58, printer 60 and memory unit 62, such as a disk drive.

The optical scanning sub-system 52 comprises a scanning controller 63, which is conected to a data bus communicating with computer 56. Scanning controller 63 provides a raster scan synchronization signal output, as well as timing outputs including an output to a UV Source Power Supply 64, which powers a UV radiation source 66. It is noted that other wavelength radiation including radiation in the visible spectrum may be used for scanning additionally or alternatively. The radiation output of the UV radiation source 66 is combined with the output of a HeNe laser 68 by a combining mirror 70 which may be of conventional construction and this combined output is supplied to a scanning assembly, typically indicated by reference numeral 72.

The HeNe laser output provides a visible marker indicating the location of the scanning radiation beam. The scanning assembly may be any suitable scanning assembly and preferably operates at a video raster scan rate. One example of such a scanning assembly is described in Israel patent 39390, entitled Optical Scan Generator, published February 10, 1975.

In the illustrated embodiment, the scanning assembly comprises a motor driven polygonal mirror 74 which receives the incoming radiation as it rotates about a central axis, producing a line scan and a separately motor driven nodding mirror 76 which receives the radiation beam reflected from the polygonal mirror and reflects it onto a planar surface 78 of the inspection chamber 50, thus producing a scan perpendicular to the line scan. A coherent raster scan pattern on the planer surface 78 is realized by coordination of the scanning motion of mirrors 74 and 76 which is achieved by the provision of suitable synchronization and control signals by the scanning controller 63 to polygon mirror control circuit 80 and nodding mirror control circuit 32 which control the operation of respective mirrors 74 and 76.

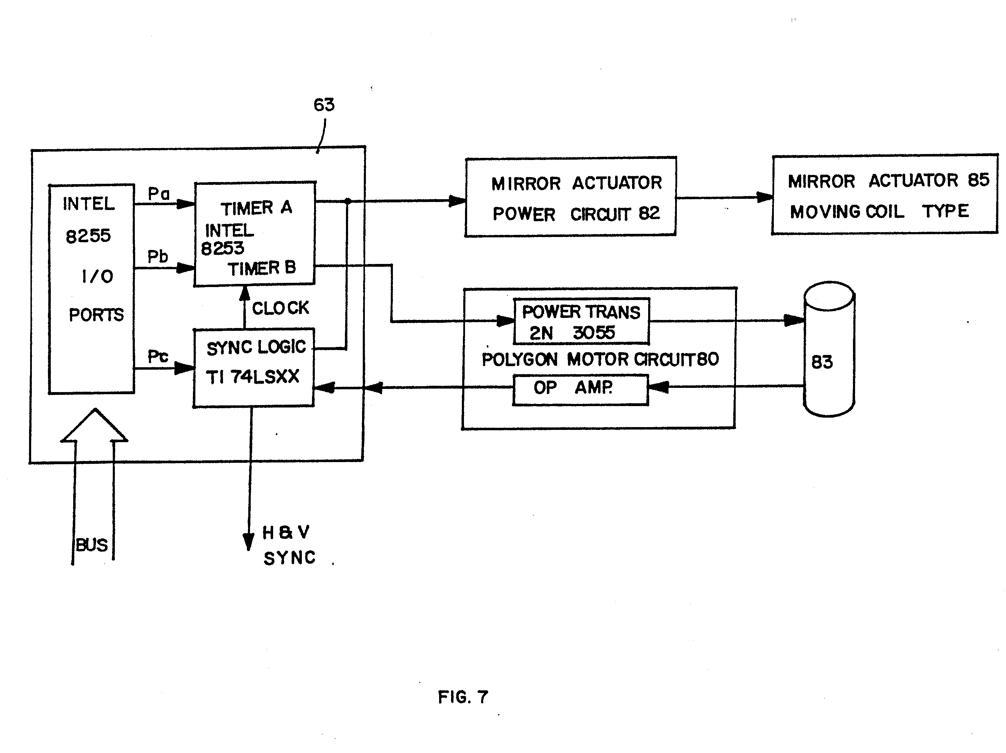

Reference is now made to Fig. 7, which illustrates the construction of scanning controller circuitry 63 and control circuits 80 and 82 in greater detail. Scanning controller circuitry 63 typically comprises an Intel 8255 chip including input and output ports which is coupled to timing circuitry such as an Intel 8253 chip and to synchronization logic circuitry such as chips of the Texas Instruments 74LSXX series. The timing circuitry typically includes timer output ports A and B, which are supplied respectively to control circuitry 80 and 82. The synchronization logic circuitry provides horizontal and vertical synchronization outputs to monitor 124 and to interface circuitry 128 (Fig. 2).

Polygon mirror control circuitry 80 typically comprises power transistors such as 2N 3055 which govern the power supply to a polygon motor and encoder 85 and an operational amplifier which receives encoder pulses from motor and encoder 85 and supplies them to the synchronization logic circuitry.

Mirror actuator power circuitry 82 typically comprises power transistors such as 2N 3055 which govern the power supply to a nodding mirror actuator 85, which may be of the moving coil type.

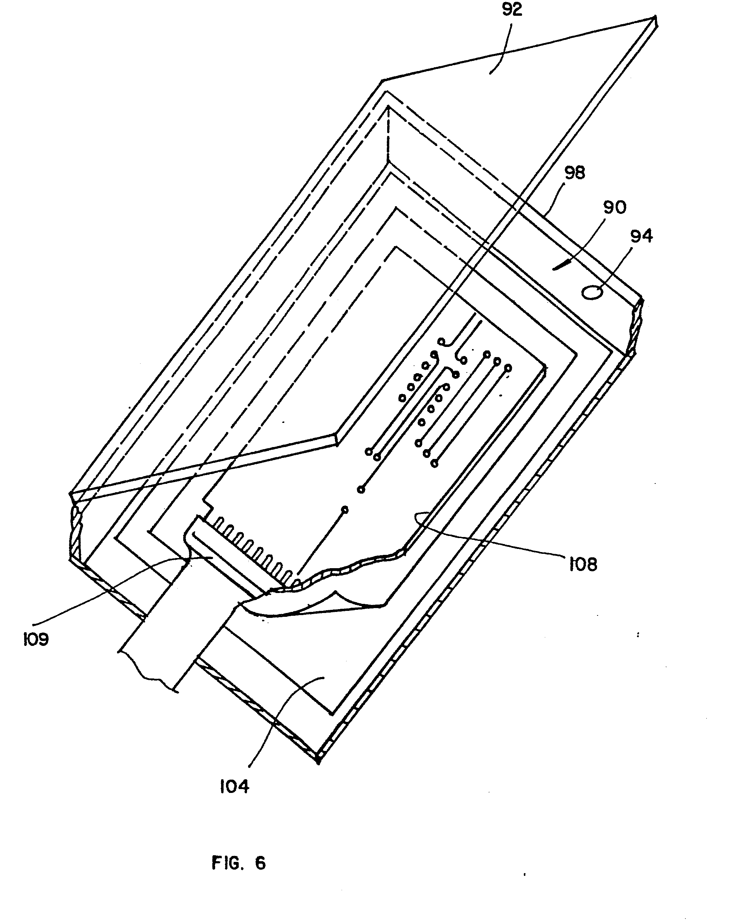

The structure and operation of the inspection chamber 50 will now be described with reference to Figs. 3 and 6. As illustrated, the inspection chamber comprises a hermetically sealable housing 90 typically formed of plastic or glass and having a radiation receiving cober 92 formed of a material which is substantially transparent to UV radiation and to HeNe radiation. The interior of housing 90 is preferably coupled via a suitable conduit 94 to a sub-atmospheric pressure producing device, such as a vacuum pump 96 (Fig. 2), which may be of the rotary type. Normally, the interior of housing 90 is maintained at a sub-atmospheric pressure of about several microns of mercury.

In the illustrated embodiment of the present invention, cover 92 is removable and removably sealed to the remainder of housing 90 by means of a peripheral gasket 98 so as to permit insertion and removal of printed circuit boards to be tested. According to an alternative embodiment of the invention, the cover surface 92 may be fixedly sealed and ingress and egress means may be provided at the sides of the housing and automatic printed circuit feeding and positioning means may be provided as well.

Disposed on the inner surface of cover 92 is a coating 100, typically of thickness equal to one quarter of the wavelength of the incoming radiation, i.e. about 0.00025mm and comprising a generally UV transparent conductor, such as Tin Oxide. Located along the inner bottom surface 102 of the housing 90 there is provided a metal plate 104 above which is disposed a layer 106 of an insulative material, such as Mylar R. A printed circuit board to be tested 108 is disposed above the insulative layer 106, supported thereon.

A suitable connector 109 may connect one or more of the circuits on the printed circuit board 108 to an electrical potential or signal source 16 (Fig. 1).

As seen in Fig. 2, the metal plate 104 is connected to a negative potential source of a power supply 110, while the transparent conductor 102 is connected via a resistor 112 typically of a few Megaohms to a positive potential source of power supply 110.

The operation of the inspection chamber 50 will now be described briefly. As the beam of UV radiation scans surface 78, it passes through conductive layer 100 and impinges on locations on the printed circuit board 108. When it impinges on a conductive location on the printed circuit board it produces a release of electrons from the conductor due to the photoelectric effect. These freeed electrons move towards the positively charged conducted 100 due to the electrostatic field established by the oppositely charged conductor 100 and metal plate 104 in the inspection chamber 50. Receipt of these electrons at conductor 100 changes the potential thereof temporarily and thus provides an electrical signal.

At the same time, the release of electrons from a conductor makes the conductor positively charged for a predetermined time until charge equilibrium is re-established. This predetermined time is of the order of 20 ms. If a different location on the conductor is impinged upon by UV radiation within the aforesaid predetermined time, while the conductor is still positively charged from the scanning of a predetermined location thereof, the conductor will release significantly less electrons.

It may be appreciated that by suitable thresholding, to distinguish conductors which have been scanned within a predetermined time frome those which have not, an output signal from the conductor 100 may be used to provide an output indication which contains mapping information as to the interconnection of conductors. This information, which coupled the synchronization information provided by the scanning controller 63 can be used to provide a visually sensible conductor map, even for a multilayer circuit board. Such a map indicates defects in a printed circuit board.

Further in accordance with a preferred embodiment of the present invention, the inspection chamber and the apparatus of Figs. 1 and 2 can be used for operational testing of loaded printed circuit boards. In this technique, test signals are supplied to the electrical circuits on the printed circuit boards by an electrical potential or signal source 16 (Fig. 1) such as a test signal generator 120, which preferably comprises an interface coupled to computer 56 by means of the data bus. The test signals may vary over time and the scanning of the circuit board is timed so as to provide conductor potential maps corresponding to a plurality of signal state combinations on the electrical circuits on the board. Suitable analysis of the conductor potential maps produced as described hereinabove, which analysis can be carried out automatically by conventional techniques, provides an operational test output indication of the loaded board.

Returning now to Fig. 2, it is seen that the output mapping signal, which is preferably a video signal, provided by a video rate raster scan, is tapped from the positive power supply connection from conductor 100 to the power supply 110. This output signal is supplied to analog/processing signal circuitry 122.

An output signal from the analog signal processing circuitry is supplied to a TV monitor 124 which also receives synchronization signals from scanning controller 63. Another output of the analog signal processing circuitry is supplied to threshold circuitry 126 which may include A/D circuitry. The output of circuitry 126 is supplied to interface circuitry 128 which also received the synchronization signals form scanning controller 63 and communicates via the data bus with computer 56.

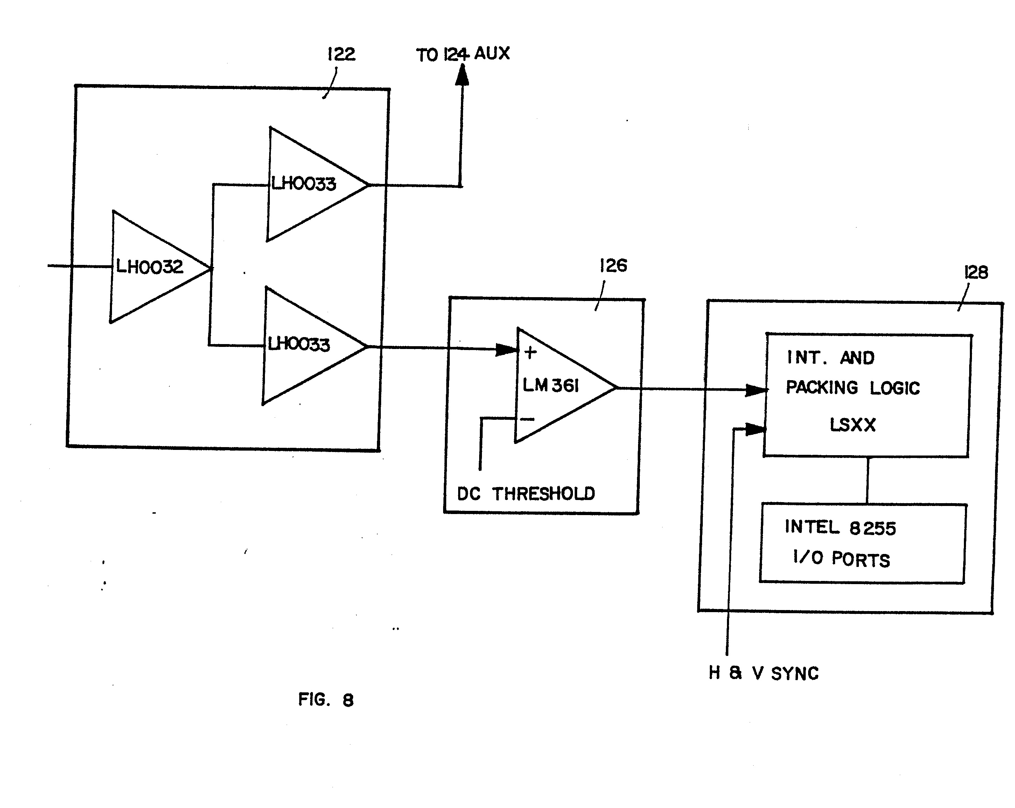

Reference is now made to Fig. 8 which illustrates a preferred embodiment of circuitry elements 122, 126 and 128. Signal processing circuitry 122 typically comprises a plurality of amplifiers such as National Semiconductors LH 0032 and LH 0033 arranged generally as illustrated. Threshold circuitry 126 comprises a comparator such as a National Semiconductor LH 361, which receives at its positive input the output from one of the amplifiers of circuitry 122 and receives at its negative input a threshold voltage and provides an output to circuitry 128. Circuitry 128 typically comprises packaging logic circuitry such as chips belonging to the Texas Instruments 74LSXX series, which receive the horizontal and vertical synchronization signals from circuitry 63 and output to interface circuitry such as an Intel 8255 chip including input output ports.

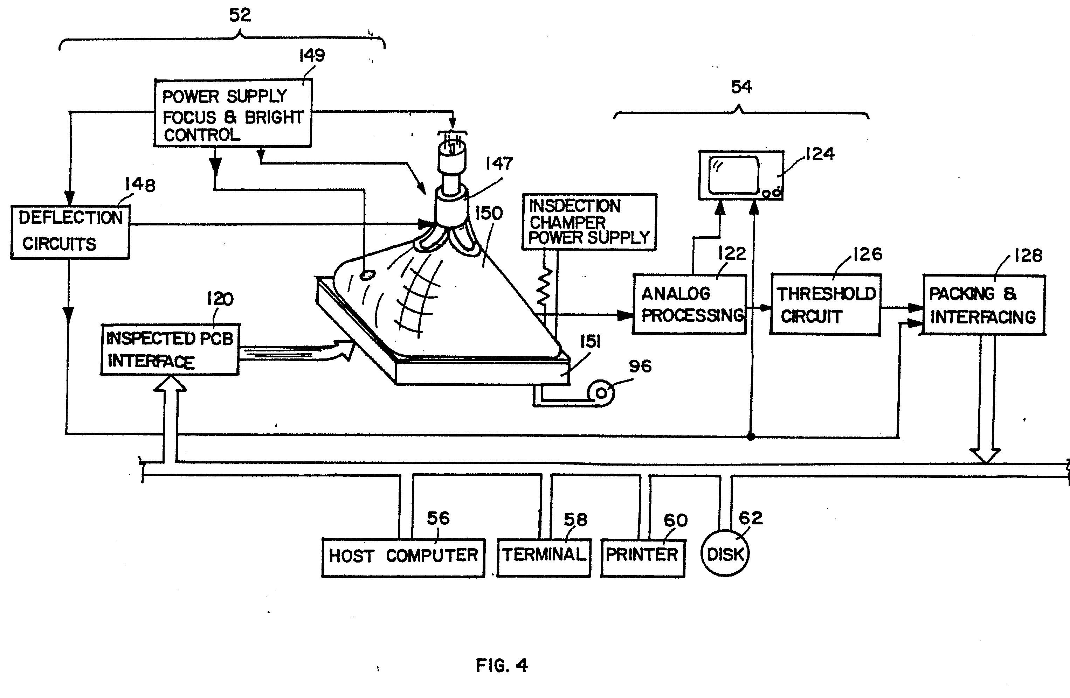

Reference is now made to Fig. 4 which illustrates an alternative embodiment of printed circuit board inspection and testing system constructed and operative in accordance with an embodiment of the present invention and employing electron beam scanning instead of optical scanning as in the embodiment of Fig. 2.

As in the embodiment of Fig. 2, the system employs a computer 56, with associated terminal 58, printed 60 and memory unit such as a disk drive 62, which communicate along a data bus. In this embodiment, the scanning sub-system comprises a CRT tube 150, such as a conventional raster scan television tube from which the phosphor screen has been removed and replaced with an inspection chamber 151, which will be described in connection with Fig. 5.

Power supply and focus and brightness controls, of conventional design and construction, collectively referenced by reference numeral 149, provide control signals to the modified CRT tube in a conventional manner. These controls provide an output signal to conventional deflection circuits 148, which provide operating signals to the yoke 147 of the modified CRT tube and also provide raster scan synchronization signals to other elements in the apparatus in a manner similar to that illustrated in Fig. 2.

Reference is now made to Fig. 5 which illustrates the inspection chamber 151 which forms part of the modified CRT tube. The inspection chamber comprises a housing 152 which is sealed to the CRT tube 150. It is seen that the inspection chamber 151 communicates with the interior of the CRT tube and is maintained at the same sub-atmospheric pressure, typically the same as in the embodiment of Fig. 3 and as in the interior of the CRT tube. The inspection chamber comprises a collecting mesh 154 which is coupled across a resistor 156 to a positive potential source at a power supply 153. At the bottom surface of the housing 152 there is provided a metal plate 158 which is coupled to a negative potential source. Above the metal plate 158 there is provided a layer of insulative material 160 typically Mylar R. The printed circuit board to be tested 162 is supported on the layer of insulative material 160.

The operation of the inspection chamber 151 will now be described briefly. When the electron beam provided by the modified CRT tube impinges on a conductor on the printed circuit board to be tested, a release of electrons is produced. These electrons are drawn to the collecting mesh due to the electrostatic field in the inspection chamber. As described hereinabove in connection with the apparatus ef Figs. 2 and 3, the electron release is a function of the charged state of the conductor, and thus of the configuration and connections of the conductor locations. As in the case of the apparatus of Figs. 2 and 3, here the signal derived from the connection of the positively connected electron receiver, here a collecting mesh, provides an output indication which can be used together with suitable synchronization inputs to provide a conductor mapping output. The downstream signal processing and display the apparatus in the embodiment of Fig. 4 is essentially the same as that in the embodiment of Fig. 2 to the level of detail illustrated herein and is therefore indicated by identical reference numerals.

It will be appreciated by persons skilled in the art that the present invention is not limited to what has been particularly shown and described hereinabove. Rather, the scope of the invention is defined only by the claims which follow:

CLAIMS

1.    Printed circuit board testing apparatus comprising:

a testing location for a printed circuit board to be tested;

high speed scanning apparatus for providing a scanned energy input to conductive locations on the printed circuit board; and

electron collecting apparatus for sensing the electrical potential of scanned conductive locations scanned by the scanning apparatus.

2.    Printed circuit board testing apparatus according to claim 1 and also comprising correlating apparatus for correlating information relating to the electrical potential of the scanned conductive locations for providing an output indication of conduction between sets of scanned locations on the circuit board.

3.    Printed circuit board testing apparatus according to claim 2 and also comprising comparison apparatus for comparing the output indication of conduction with a predetermined reference indication corresponding to a master circuit board.

4.    Printed circuit board testing apparatus according to any of the preceding claims and also comprising means for providing at least one predetermined electrical input to the printed circuit board being tested.

5.    Printed circuit board testing apparatus according to claim 4 and wherein said electrical input providing means provides at least one time varying electrical input to the printed circuit board and said correlating apparatus provides a plurality of output indications each corresponding to a different state of the electrical input supplied to the printed circuit board.

6.    Printed circuit board testing apparatus according to any of the preceding claims and wherein said scanning apparatus comprises optical scanning means.

7.    Printed circuit board testing apparatus according to claim 6 and wherein said optical scanning means comprises UV scanning means.

8.    Printed circuit board testing apparatus according to any of the preceding claims 1 to 5 and wherein said scanning apparatus comprises electron scanning means.

9.    Printed circuit board testing apparatus according to any of the preceding claims and wherein said testing location comprises a sub-atmospheric pressure enclosure.

10.    Apparatus substantially as shown and described hereinabove.

11.    Apparatus substantially as illustrated in any of the drawings.

FIG. I

0128107

FIG. 2

FIG. 5

FIG. 3

FIG. 4

FIG. 6

FIG. 7

FIG. 8

0128107

## European Patent Office

## EUROPEAN SEARCH REPORT

Application number

EP 84 63 0072

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | DE-A-2 309 371 (VEB STEREMAT) * Claim 1; pages 4-6; figure 1 * | 1,2 | G 01 R 31/28 |
| A | | 10,11 | |
| X | * Claim 15 * | 3-5 | |
| A | * Claim 7 * | 9 | |
| | --- | | |
| X | DE-A-2 700 252 (LICENTIA) * Claims 1, 2, 4 * | 1-6,8 | |
| | --- | | |
| A | THE TRANSACTIONS OF THE IECE OF JAPAN, vol. E 64, no. 5, May 1981, Tokyo, JP; H. FUJIOKA et al. "Function testing of bipolar and MOS LSI circuits with a combined stroboscopic SEM-microcomputer system", pages 295-301 * Pages 295-301 * | | TECHNICAL FIELDS SEARCHED (Int. Cl. ³) G 01 R 31/28 |
| | --- | | |
| A | MICROELECTRONICS & RELIABILITY, vol. 20, no. 5, 1980, Oxford, GB; M. NAGASE "A device analysis system based on laser scanning techniques", pages 717-735 * Pages 717-735 * | | |
| | --- -/- | | |

The present search report has been drawn up for all claims

| Place of search | Date of completion of the search | Examiner |
|---|---|---|
| BERLIN | 31-07-1984 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82

European Patent
Office

EUROPEAN SEARCH REPORT

Application number

EP 84 63 0072

| Category | DOCUMENTS CONSIDERED TO BE RELEVANT | | Page 2 |

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | TECHNISCHES MESSEN, vol. 48, no. 1, January 1981, München; P. FAZEKAS "Elektronenstrahl prüft elektrische Potentiale in integrierten Schaltungen", pages 29-35 <br> * Pages 29-35 * | | |

TECHNICAL FIELDS
SEARCHED (Int. Cl. ³)

The present search report has been drawn up for all claims

| Place of search | Date of completion of the search | Examiner |
|---|---|---|
| BERLIN | 31-07-1984 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82